# EUROPEAN PATENT SPECIFICATION

(11) **EP 3 426 976 B1**
(45) Date of publication and mention of the grant of the patent: **24.02.2021**
(21) Application number: 17710506.1
(22) Date of filing: 07.03.2017
(51) Int. Cl.: H05K 1/18, F21V 19/00, F21V 23/00, F21V 19/04, H05K 1/14, H05K 3/00, H05K 3/32, F21Y 115/10

(54) **SOCKET ASSEMBLY, LIGHT EMITTER MODULE, AND LIGHTING SYSTEM**
BUCHSENANORDNUNG, LICHTEMITTIERENDES MODUL UND BELEUCHTUNGSSYSTEM
ENSEMBLE DOUILLE, MODULE ÉMETTEUR DE LUMIÈRE, ET SYSTÈME D'ÉCLAIRAGE

(30) Priority: 11.03.2016 DE 102016204079
(43) Date of publication of application: 16.01.2019
(73) Proprietor: TE Connectivity Nederland B.V., 5222 AR s'Hertogenbosch (NL); Tyco Electronics UK Ltd, Wiltshire SN3 5HH (GB)
(72) Inventor: IEDEMA, Jeroen, 8478 HB Sonnega (NL); LEIJNSE, Olaf, 5721 RD Asten (NL); POORTER, Peter, 4261 LD Wijk en Aalburg (NL); CATCHPOLE, Jonathan, West Hanney Oxfordshire OX12 0LF (GB)
(74) Representative: Grünecker Patent- und Rechtsanwälte PartG mbB
(86) International application number: PCT/EP2017/055300
(87) International publication number: WO 2017/153394

(56) References cited:
- EP-A2- 2 623 854
- US-A1- 2010 163 914
- US-A1- 2010 219 758
- US-A1- 2014 063 814

## Description

The present invention generally relates to solid state lighting (SSL) systems based on semiconductor light emitting elements, such as light emitting diodes (LED) or semiconductor lasers, for instance vertical cavity surface emitting lasers (VCSEL). The following examples mainly refer to LED light emitting elements. The principles according to the present invention are, however, also applicable to all other solid state light sources that use semiconductor dies as light emitting elements.

LED lighting systems typically include one or more LED packages that include one or more LEDs on a printed circuit board (PCB), which is referred to herein as an "LED PCB". The LED packages may be what is commonly referred to as a "chip-on-board" (COB) LED, or may be any other type of LED package, such as, but not limited to, an LED package that includes an LED PCB and one or more LEDs soldered to the LED PCB. Lighting systems that are based on semiconductor lasers, e. g. VCSEL arrays, may of course be assembled according to the same principles as LEDs and have to meet the same strict requirements regarding thermal management and size reduction.

In known LED lighting systems, the LED package is held within a recess of a socket housing that is mounted to a support structure of the lighting fixture, for example a base, a heat sink, and/or the like. When the LED package is held by the socket housing, the socket housing may apply a force to the LED package to press the LED package toward the support structure. For example, the force applied by the socket housing may hold the LED PCB in engagement with the support structure or a thermal interface material that extends between the LED PCB and the support structure. But, the force applied by the socket housing to the LED package may cause the LED package to fail. For example, the force applied to the LED package by the socket housing may be sufficiently high to fracture (e.g., crack, break, and/or the like) the LED PCB. Moreover, and for example, the force applied by the socket housing to the LED package may be insufficient to securely hold the LED package between the socket housing and the support structure, which may allow the LED package to vibrate and thereby fracture or otherwise fail.

Furthermore, it is a need in the market that LED lighting systems should be dimmable and that the control of their luminous output can be performed easily by a user or an automatic system.

Known LED lighting systems, however, are mostly too bulky and do not provide a sufficiently thermal management for a further miniaturization.

From the published International Application WO 2015/101420 A1 and from EP 2623854 A2, an LED socket assembly is known that uses a metal base frame for holding an LED package to a support structure.

US 2010/163914 A1 discloses light emitting device, in which an encapsulation resin is disposed at a space confined between an optical member and a mounting substrate. This encapsulation resin is possibly made free from a void-generation therein. In this light emitting device, the optical member can be precisely positioned. An electrode disposed outside a color conversion member is possibly free from an improper solder connection. A ring gate is formed on the top surface of the mounting substrate outside of the optical member, and acts to position the color conversion member. The ring gate acts to prevent an overflowing liquid encapsulation resin from flowing to the electrode provided. The ring gate is provided with a plurality of centering projections which are spaced circumferentially along its inner circumference to position the color conversion member.

US 2010/219758 A1 discloses a lighting device comprising a plurality of lighting modules which include a module carrier on which a light source with a plurality of controllable light-emitting diodes emitting light of different wavelengths and arranged on a board, a temperature sensor, and a module electronic are arranged. Said module electronic contains a digital circuit with a microcontroller for the local and autonomous signal processing, which actuates the LEDs in dependence on the temperature such that the brightness, color and chrominance of the light mixture composed of the LEDs emitting light of different wavelengths is constant. Said lighting modules being connected with other lighting modules or an external controller via a digital interface for transmitting the board temperature of the respective lighting module detected by means of the temperature sensor. A central master module or the external controller actuates the lighting modules such that a uniform brightness is obtained over the radiating surface.

There is still a need for an improved socket assembly, a corresponding light emitter module and a solid state lighting system providing maximum functionality with minimum space requirements and an efficient thermal management, being cost efficient and easy to assemble at the same time.

This object is solved by the subject matter of the independent claim 1. Advantageous embodiments of the present invention are the subject matter of the dependent claims.

The present invention further relates to a socket assembly for receiving a solid state light emitter package. The socket assembly comprises a thermally conductive base frame for holding a light emitter package to a support structure, the light emitter package having a light emitter substrate with a light emitting element mounted thereto, wherein the base frame comprises a base that is configured to be mounted to the support structure and is further configured to mechanically engage a light emitter substrate of the light emitter package, so that the light emitter package is attachable to the support structure with a pre-determined holding force; at least one electrical contact element for electrically contacting said light emitter package; and an isolator printed circuit board (PCB) comprising a plurality of electrically conductive leads, wherein the electrical contact element is arranged on the isolator PCB such that the electrical contact element electrically connects the isolator PCB to the light emitter substrate, the isolator PCB being configured to be electrically connected to the electrical power supply for supplying electrical power to the light emitting element. The isolator PCB has a first surface and a second surface, the second surface being in heat transmitting contact with the base frame, such that the base frame is configured to absorb heat from the isolator PCB, wherein the light emitter module further comprises at least one electronic component, which is arranged on said first surface of the isolator PCB and is electrically connectable to said light emitting element.

The arrangement according to the present invention has the advantage that the heat conductive base frame is in direct contact with the light emitter package and that part of the isolator PCB where electronic components are mounted. In this manner, heat can be absorbed and conducted to a support structure that preferably functions as a heat sink. Moreover, all electronic components that are needed for the operation of the light emitting element can be integrated directly into the housing of the light emitter module. This architecture allows for a particularly compact, space saving configuration and a flexible and fast installation.

A further advantage of the architecture according to the present invention can be seen in providing a socket assembly that can be sold separately from the light emitter package, so that a customer has maximum flexibility in choosing the desired light source. Moreover, an efficient, environmentally friendly, and cost effective replacement of defective light emitter packages is possible.

In particular, the at least one electronic component may comprise a driver unit for providing a controlled power to said light emitting element. In the case of an LED, such driver electronics for instance comprise the required circuitry for providing a controlled forward current (IF) to the one or more diodes. Furthermore, at least a part of the LED driver electronics may use highly integrated passive and active components that may be integrated in the printed circuit board (PCB) using structured layers of different materials.

According to an advantageous embodiment, the at least one electronic component that is arranged inside the socket assembly comprises a communication interface for communication with an external controller. Thus, the operation of the light emitting element can be controlled by a user or a superordinate system, such as a building control system. The communication interface advantageously is based on a wirebound communication protocol so that any screening effects by the electrically conductive parts inside the socket assembly do not affect the communication. For instance, the wirebound power over Ethernet (PoE) communication may be used. Any other suitable protocol may of course also be used by the communication interface of the present invention.

Providing such an interface advantageously allows controlling the light emitter module with high flexibility by any desired means, for instance via a mobile device using Internet of Things (loT)/cloud services.

According to an advantageous embodiment of the present invention, the at least one electronic component comprises a dimming unit for controlling a luminous flux emitted by the light emitting element. In the case of the light emitting element being an LED, there exist two major approaches to dimming the LEDs: pulse width modulation (PWM) and analog. Both approaches can be used according to the present invention, but PWM is preferred because PWM dimming greatly reduces color changes in the LED with varying brightness levels, because the LED essentially runs at a constant current when it is on and at no current when it is off. However, this advantage comes at the expense of additional logic to create the PWM waveforms. With the present invention it is possible to integrate this additional logic into the socket assembly of the light emitter module.

The average forward LED current determines the brightness of an LED. The relationship between forward LED current versus lumens of optical output for a given LED is remarkably linear over usable ranges of forward current (IF). PWM dimming switches the LED on and off at a high rate. The effective IF becomes the time-based average of IF when the LED is on and when it is off. When using the PWM method of LED dimming, the on/off frequency must be faster than the human eye can detect to avoid visible flicker. PWM frequencies of 200 Hz or greater usually avoid flicker problems.

According to the present invention, the socket assembly has a PWM unit that receives an analog DC or digital control signal at its input terminal and outputs at its output terminal an alternating PWM signal for controlling the driver unit. The control signal is for instance a 0 V to 10 V DC signal, 0 V representing the OFF state of the light emitting element, and 10 V representing a maximum (100 %) brightness. However, it is clear for a person skilled in the art that any other suitable input signal that indicates a desired brightness value to the PWM unit can also be chosen.

According to an advantageous embodiment, the socket assembly has at least one electrical contact element (usually two) which is resilient and is arranged at the isolator PCB as to exert a defined force on the light emitter package in its mounted state. This resilient construction ensures that the forces which act on the light emitter package do not depend on the forces exerted by any fixing means that fix the socket assembly to the support structure, e. g. the torque of one or more screw connections.

The socket assembly may further comprise an electrical connector that is arranged on the isolator PCB and is configured to be mated with a mating connector for supplying power to the light emitting element. This allows a particularly flexible, modular setup providing for an easy and flexible assembly and installation of the light emitter module. Apart from a plug connection based on two mating connectors, also a connector that directly receives the end of a wire, e. g. a connector with insulation displacement contacts (IDC), a luster terminal, or the like can be used according to the present invention.

In order to achieve a secure and robust mounting of the light emitter package, the thermally conductive base frame comprises at least one resilient element that extends from the base, the resilient element being configured to engage the light emitter substrate of the light emitter package and to apply a clamping force to the light emitter substrate.

According to an advantageous embodiment, the thermally conductive base frame is fabricated from a stamped and bent metal sheet. This is a technology that on the one hand provides a low cost and stable base frame and on the other hand provides excellent heat conducting properties. However, also thermally conductive polymers or ceramics may also be used for fabricating the base frame according to the present invention.

According to the present invention the socket assembly comprises a cover that includes an opening that is configured to expose the light emitting element, the cover comprising a retention feature that cooperates with a retention member of the base frame to mechanically connect the cover to the base frame. In this manner, the socket assembly (and also the light emitter module after the light emitter package has been mounted) may be assembled and shipped without being attached to a support structure and still be mechanically protected.

The present invention further relates to a light emitter module comprising a socket assembly according to the present invention and a light emitter package having a light emitter substrate with a light emitting element mounted thereto.

The present invention further relates to a lighting system comprising a light emitter module according to the present invention as described above and a control unit for controlling said electronic component. The control unit may either be a built-in control of a building system or a remote control unit that may wirelessly communicate with the light emitter module. In particular, the lighting system comprises such a light emitter module and an inline control unit for controlling the at least one electronic component. Thus, the control of the light emitting element is performed using the inline control unit that is arranged outside the socket assembly of the light emitter module and is connected to the isolator PCB via a cable. Such an inline control unit allows for a high flexibility when integrating the light emitter module according to the present invention into superordinate lighting systems.

Further, a communication interface may also be integrated into the inline control module.

The communication interface may either the wirebound or wireless, depending on the standards and protocol that are to be used for the communication. For instance, the wirebound power over Ethernet (PoE) communication may be used. Other possible protocols that are envisaged together with the communication interface of the present invention are Bluetooth Low Energy (BLE), IPv6 over Low power Wireless Personal Area Network (6LoWPAN), ZigBee (an IEEE 802.15.4-based specification for a suite of high-level communication protocols used to create personal area networks), KNX (a standardized (EN 50090, ISO/IEC 14543), OSI-based network communications protocol for building automation), or Thread (an IPv6-based, closed-documentation protocol for Internet of Things, loT). It is clear for a person skilled in the art that any particular communication protocol can be chosen as needed.

Providing such an interface advantageously allows controlling the light emitter module with high flexibility by any desired means, for instance via a mobile device, via a dedicated remote control, or by using loT/cloud services.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. Further features and advantages will become apparent from the following more particular description of the various embodiments of the invention, as illustrated in the accompanying drawings, in which like references refer to like elements, and wherein:
- **FIG. 1**: is an exploded perspective view of an exemplary embodiment of a socket assembly for a light emitter module;
- **FIG. 2**: is a perspective view of a light emitter module using the socket assembly according to FIG. 1 without the cover being attached;
- **FIG. 3**: is a top view of the light emitter module without cover shown in FIG. 2;
- **FIG. 4**: is a perspective view of an exemplary embodiment of an isolator PCB;
- **FIG. 5**: is a perspective view of an exemplary embodiment of a cover;
- **FIG. 6**: is a perspective view turned by 180° of the cover shown in FIG. 5;
- **FIG. 7**: is a detail of the isolator PCB shown in FIG. 1;
- **FIG. 8**: is a perspective view of an exemplary embodiment of a contact element;
- **FIG. 9**: is a perspective view of an exemplary embodiment of a base frame;
- **FIG. 10**: is a schematic circuit diagram of a first architecture for operating an LED module;
- **FIG. 11**: is a schematic circuit diagram of a second architecture for operating an LED module;
- **FIG. 12**: is a schematic circuit diagram of a further architecture for operating an LED module;
- **FIG. 13**: is a schematic circuit diagram of still a further architecture for operating an LED module.

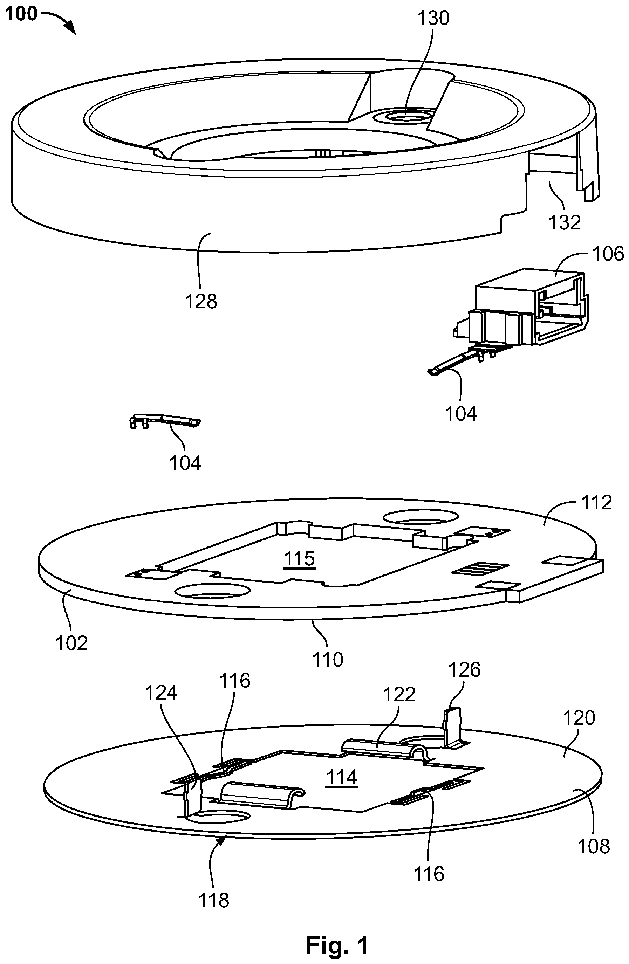

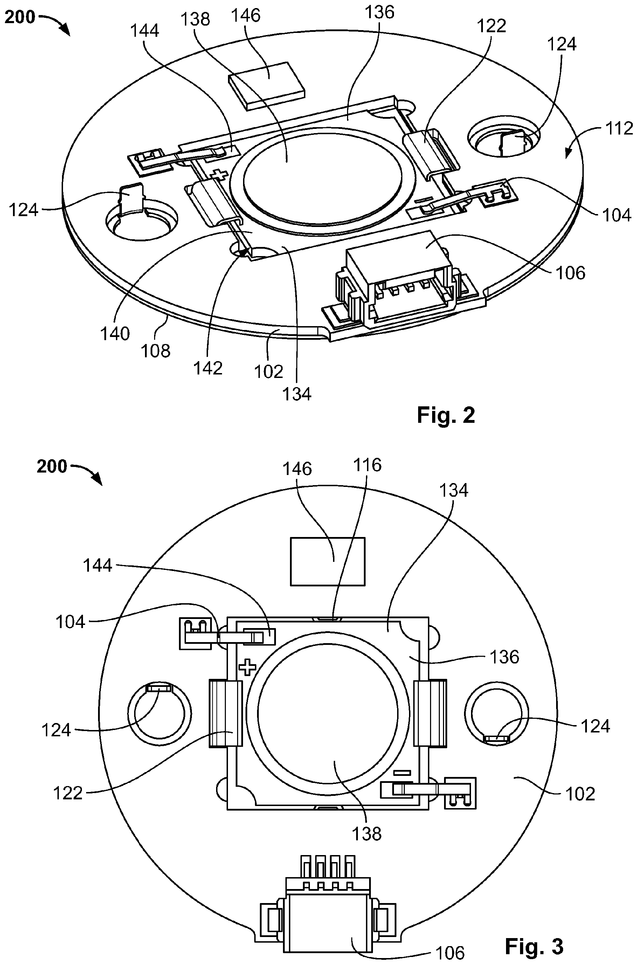

The present invention will now be explained in more detail with reference to the Figures and firstly referring to Fig. 1. Figure 1 is a perspective view of an exemplary embodiment of a socket assembly 100 (also referred to as a "holder") for mounting a light emitting diode (LED) package (shown in Figures 2 and : 3) as a light emitter package. Together with the assembled at least one LED (or any other light emitting element) the socket assembly 100 forms a light emitter module according to the present invention.

The light emitter module may be part of a light engine, a light fixture, or other lighting system that is used for residential, commercial, and/or industrial use. The light emitter module may be used for general purpose lighting, or alternatively, may have a customized application and/or end use.

The light emitter module is mounted on a support structure (not shown in the Figures). The support structure may be any structure to which the socket assembly 100 is capable of being mounted to, such as, but not limited to, a base, a heat sink, and/or the like. In the exemplary embodiment, the support structure is a heat sink. The support structure usually includes a mounting surface to which the socket assembly is mounted. Optionally, at least a portion of the mounting surface is approximately flat. The support structure may include one or more mounting features (e.g., threaded openings) for mounting the socket assembly to the support structure, as this is generally known in the art.

As will become apparent from Figures 2 and 3, the socket assembly 100 comprises an isolator printed circuit board (PCB) 102 which is electrically connected to the LED package. For electrically contacting respective contact pads of the LED package, the socket assembly 100 comprises contact elements 104 which are preferably resilient, e. g. formed as metal springs. furthermore, an electrical connector 106 is provided which is electrically contacting electrically conductive leads on the PCB and is connectable to a belonging mating connector (not shown in the Figures).

According to the present invention, a thermally conductive base frame 108 is arranged between the PCB 102 and the support structure as mentioned above. The base frame advantageously is fabricated as a stamped (or laser cut) and bent metal sheet, for instance from copper. Advantageously, the base frame 108 has an essentially flat shape so that it is in thermal contact with the PCB 102 on one surface and with the support structure on its other surface.

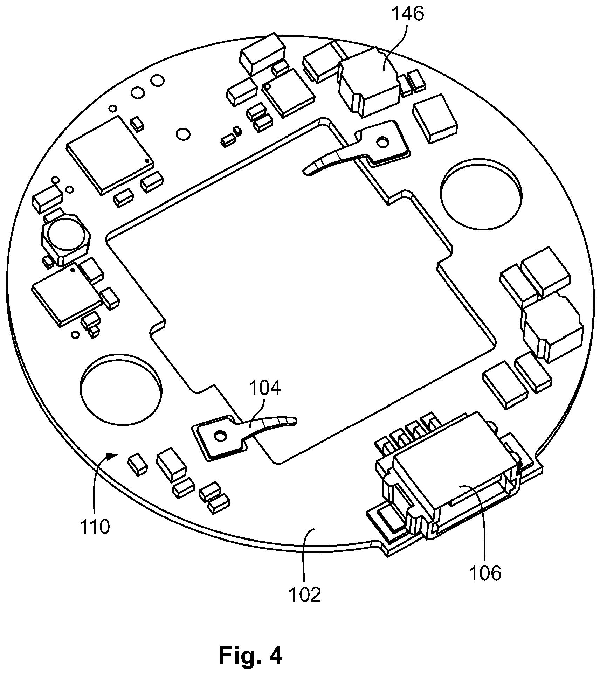

As will be apparent from Fig. 4, the PCB 102 carries at least one electronic component which is arranged on a first surface 112 of the PCB 102. In the following, the first surface 112 will be referred to as the "upper" surface, whereas the second surface 110 of the PCB 102 will be referred to as the "lower" surface. Due to the direct thermal contact between the lower surface 110 of the PCB 102 and the thermally conductive base frame 108, a particularly effective heat dissipation of the heat generated by the electronic component can be achieved.

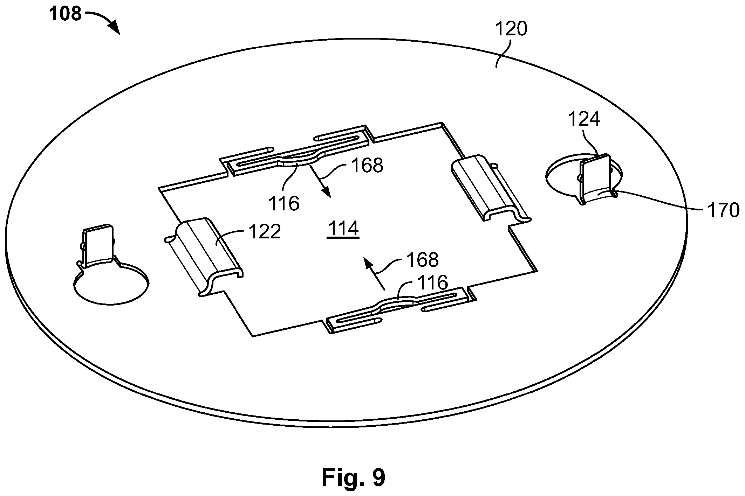

Furthermore, the base frame 108 comprises a recess 114 for receiving the LED the package. As will be apparent from Fig. 9, the base frame comprises two compressible spring elements 116 that extend radially inward into the recess 114 and exert a clamping force on the LED package within the plane of the recess 114. Consequently, the LED package is secured at the base frame 108 even without a support structure being present. Moreover, by resiliently engaging with the LED package, same is attachable to the support structure with a pre-determined holding force independent of the influence of further fixing means that fix the socket assembly to the support structure, e. g. the torque of mounting screws.

The base frame 108 includes a body 118, which includes a base 120 and one or more spring fingers 122 that extend from the base 120. As will be described below, the spring finger 122 is configured to engage the LED package (Figures 3 and 4) to apply a clamping force to the LED PCB (Figures 3 and 4) to hold the LED package to the support structure. A cut-out 115 is provided in the PCB 102 that essentially matches the outline of the recess 114 and allows the LED package and the spring fingers 122 to pass through..

The body 118 of the base frame 108 includes one or more optional anvils 124 that extend outward from the base 120. Specifically, in the exemplary embodiment, each anvil 124 extends outward from the base 120 along a central axis of the base 120 to an end 126. The ends 126 are each configured to be engaged by a corresponding fastener such that the fastener applies a clamping force to the base frame 108. Although two are shown, the base frame 108 may include any number of the anvils 124.

Furthermore, a cover 128 is provided that covers the PCB 112 and most of the LED package for providing electrical and mechanical protection. For instance, the cover is formed as a molded part from plastic material. The cover 128 comprises openings 130 that are configured to receive a fastener, e. g. a screw or bolt for mounting the cover to a support structure.

A cut-out 132 which is provided at the cover 128 allows the electrical connector 106 to be connected to a mating connector (not shown in the Figures).

With reference to Figures 2 and 3 the complete light emitter module 200 will be explained. For the sake of clarity the cover 128 is not shown in these drawings. As can be seen from these Figures, the light emitter module 200 comprises an LED package 134 having an LED as light emitting element. As already mentioned above, any other solid state lighting element, for instance a semiconductor laser, may also be provided according to the present invention.

The LED package 134 includes an LED printed circuit board (PCB) 136 with an LED 138 mounted thereto. In the exemplary embodiment, a single LED 138 is mounted to the LED PCB 136, however, any number of LEDs 138 may be mounted to the LED PCB 136. The LED PCB 136 may be sized appropriately depending on the number of LEDs 138 mounted thereto. The LED PCB 136 includes opposite sides 140 and 142. The LED 138 is mounted on the side 140 of the LED PCB 136. The LED package 134 includes one or more power pads 144 on the LED PCB 136.

In the exemplary embodiment, the LED package 134 is what is commonly referred to as a "chip-on-board" (COB) LED. But, the LED package 134 may be any other type of LED package, such as, but not limited to, an LED package that includes an LED PCB and one or more LEDs soldered to the LED PCB. The LED PCB 136 includes a rectangular shape in the exemplary embodiment. But, the LED PCB 136 may additionally or alternatively include any other shape, which may depend on the type and/or number of LEDs 138 mounted to the LED PCB 136. A substrate of the LED PCB 136 may be fabricated from any materials, such as, but not limited to, a ceramic, polytetrafluoroethylene, FR-4, FR-1, CEM-1, CEM-3, FR-2, FR-3, FR-5, FR-6, G-10, CEM-2, CEM-4, CEM-5, an insulated metal substrate (IMS) and/or the like.

The body 118 of the base frame 108 includes the spring fingers 122. Although two are shown, the body 118 may include any number of the spring fingers 122. Each spring finger 122 is configured to engage the LED PCB 136 to apply a clamping force to the LED PCB 136, which acts on the LED PCB 136 in a direction toward the support structure. Specifically, each spring finger 122 extends from the base frame 108 in a radially inward direction relative to the central axis. Each spring finger 122 is configured to engage the LED PCB 136. The spring finger 122 is a resiliently deflectable spring that engages the LED PCB 136. Specifically, when the base frame 108 is used to hold the LED package 134 to the support structure, each spring finger 122 engages a side of the LED PCB 136 and is deflected thereby in a direction away from the support structure (not shown in the Figures). In the deflected position, the spring finger 122 exerts the clamping force on the side of the LED PCB 136 that acts in a direction toward the support structure.

Various parameters of the spring fingers 122 may be selected such that it provides a predetermined clamping force, or range thereof, to the LED package 134. Such parameters of the spring fingers 122 include, but are not limited to, the number of spring fingers 122, the geometry (e.g., shape) of each of the spring fingers 122, the dimensions (e.g., length, width, thickness, and/or the like) of each of the spring fingers 122, the location of each of the spring fingers 122 along the base frame 108, the orientation of each of the spring fingers 122 relative to the base frame 108, the materials of each of the spring fingers 122, and/or the like. The various parameters of the spring fingers 122 may be selected to provide a predetermined clamping force, or range thereof, that facilitates preventing failure of the LED package 134.

Moreover, in order to hold the LED package 134 in place while the light emitter module 200 is not attached to a support structure, lateral spring elements 116 are provided at the base frame 108 for clamping the peripheral edges of the LED PCB 136. According to the present invention, one or more electronic components 146, such as a driver unit and/or a communication interface (represented only schematically in Figures 2 and 3), are arranged on the first surface 112 of the isolator PCB 102.

Figure 4 shows an example of a fully populated isolator PCB 102 comprising the active and passive elements of a driver circuit for driving the LED with a controlled electrical DC power. The interconnecting leads (not visible in the Figures) may be arranged on the surface 110 of the isolator PCB 102 or may be buried in deeper layers of the isolator PCB 102, the isolator PCB 102 being formed as a multilayer PCB as this is known in the art.

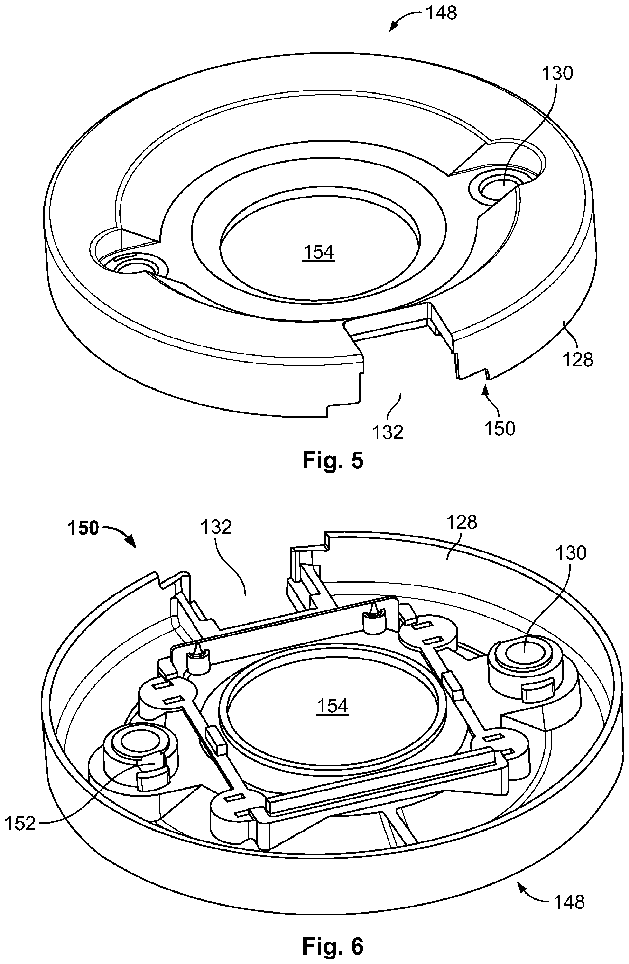

Figures 5 and 6 illustrate in a perspective view from two opposing sides an exemplary embodiment of the cover 128 of the light emitter module 200. The cover 128 extends a thickness from a side 140 to an opposite side 150. The side 150 of the cover 128 faces toward the mounting surface of the support structure.

The cover 128 may include one or more mounting members 130 that are used to mount the cover 128 to the support structure. Each mounting member 130 cooperates with a corresponding mounting feature (e.g., the openings) of the support structure to mount the cover 128 to the support structure. The cover 128 may include any number of the mounting members 130, each of which may be any type of mounting member. In the exemplary embodiment, the cover includes two mounting members 130, which are openings that are configured to receive fasteners (not shown in the Figures). But, each of the mounting members 130 may additionally or alternatively be any other type of mounting member, such as, but not limited to, a post, a latch, a spring, a snap-fit member, an interference-fit member, a rivet, a pop rivet, a threaded fastener, and/or the like. Optionally, the cover 128 includes one or more openings 152 that receive the anvils 124 (Figures 1 to 3) of the base frame 108.

The cover 128 may include one or more cut-outs 132 for giving access to the electrical connector 106.

The cover 128 includes an opening 154 that enables the LED 138 to be exposed. The opening 154 may have any size and any shape. In the exemplary embodiment, the opening 154 has a circular shape and a complementary size relative to the LED 138. The cover 128 may further include one or more optic features (e.g., a lens, a screen, a transparent cover, and/or the like) that extend over the opening 154. The LED 138 may be considered to be exposed by the opening 154 through the optic feature.

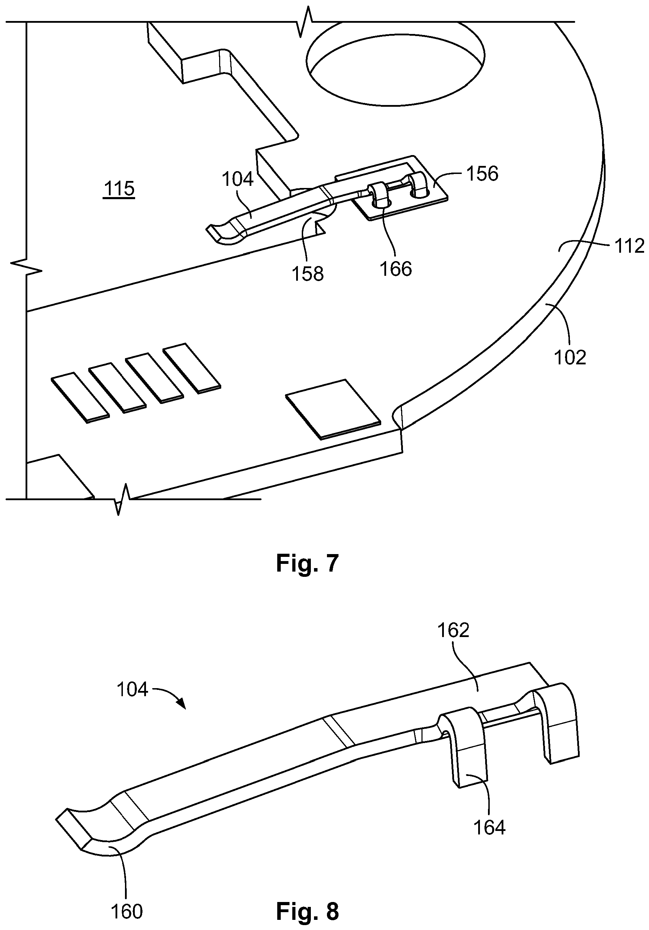

Fig. 7 shows a detail of the PCB 102 in order to explain the shape of the contact element 104. The contact element 104 has an elongated form and is fabricated from a resilient, electrically conductive material, e.g. metal. the contact element 104 protrudes into the cut-out 115 in order to electrically contact the power pads 144 of the LED package 134. The contact element 104 is formed as a cantilever that is fixed at a solder pad 156 arranged on the first surface 112 of the PCB 102. A notch 158 allows the contact element 104 to be mechanically biased against the surface of the LED package carrying the power pads 144.

In Figure 8 the contact element 104 is shown in detail. The contact element 104 has a contact region 160 electrically contacts the power pad 144 of the LED package 134. the contact region has a curved outline in order to provide a line -shaped about thing contact between the power pad 144 and the contact element 104.

At the opposing peripheral end of the contact element 104 a connecting region 162 is provided that connects the contact element 104 to the printed circuit board 102. According to the present embodiment, the connecting region comprises two connecting pins 164 that are introduced into connecting receptacles 166 of the PCB 102. A solder connection firmly fixes the contact element 104 at the solder pad 156. However, it is clear for a person skilled in the art that the pins 164 may also be the only connection being formed as a press fit connection. Moreover, any number of connecting pins 164 (or none at all) is of course possible.

Fig. 9 shows an exemplary embodiment of the base frame 108 according to this embodiment, the base frame is formed from a stamped and bent metal sheet. However, also suitably thermally conductive plastic materials or cast metal can also be used according to the present invention. According to the present invention, the base frame 108 has a smooth base 120 that provides a large area thermal contact to the second surface 110 of the PCB 102. Consequently, heat generated by electronic components assembled on the first surface 112 of the PCB 102 can easily be dissipated. The LED package 136 is laterally held by spring elements 116. The spring anger 122 price the LED package 134 on to a support structure in the finally mounted state. But also with out a support structure being present, the LED package is fixed at the base frame 108 by the operation of the spring elements 116 that third force is within the plane of the recess 114 as indicated by the arrows 168.

The anvils 124 are formed to have a resilient base 170. Hence, the anvils 124 are fixed at the base 120 of the base frame 108 resiliently so that any tolerances can be compensated in order to ensure an optimal thermally conducting contact between the base frame 108 and the PCB 102.

According to the present invention, the PCB 102 not only provides electrically conductive leads and contact pads for connecting the LED package 134 to external electronic components, but also serves as a substrate for electronic components 146. The electronic components 146 can be formed by discrete components assembled on the first surface 112 of the PCB 102 and/or by components that are integrated into a multilayer PCB 102. The electronic components may comprise passive components, such as resistors, capacitors, or coils, and active components, such as controllers, sensors, or semiconductor switches.

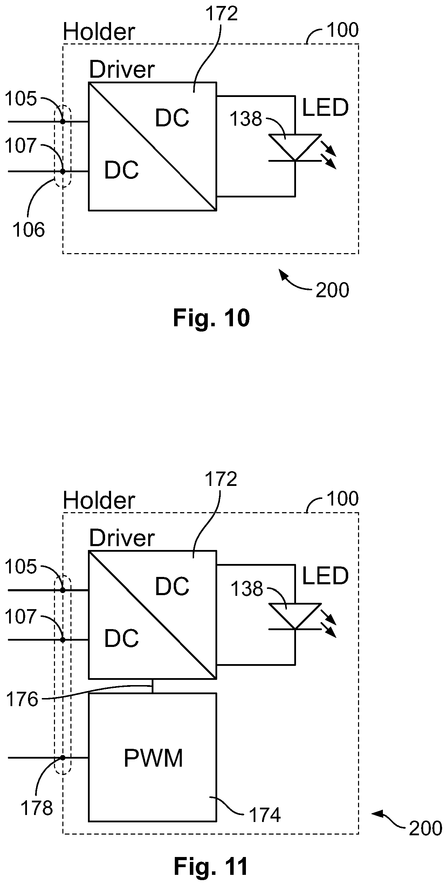

Fig. 10 shows a first exemplary embodiment of a light emitter module 200 comprising an integrated driver unit 172. The driver unit 172 is assembled on the PCB 102 and therefore needs no additional space. Further, it can be ensured that the LED 138 is never operated with a non-compatible driver circuit. In this exemplary embodiment, the light emitter module 200 is provided via the electrical connector 106 with an input voltage in the ON state of an external switch or with no power in the OFF state of the external switch. Depending on the input at the connector 106, the driver unit 172 provides a forward current (IF) to the LED 138, causing same to emit radiation. For instance, a first input terminal 105 of the driver unit 172 is connected to a 0 V reference potential, and a second input terminal 107 of the driver unit 172 is connected to a 48 V power supply.

According to a further exemplary embodiment, which is illustrated in Figure 11, means for dimming the LED may also be provided inside the light emitter module 200. For instance, a dimming unit 174 may comprise a pulse width modulator (PWM) unit 174 that is connected to a control terminal 176 of the driver unit 172. According to the present invention, the PWM unit 174 controls the driver unit 172 so that it switches the LED 138 on and off at a high rate. The effective IF becomes the time-based average of IF when the LED is on and when it is off. When using the PWM method of LED dimming, the on/off frequency must be faster than the human eye can detect to avoid visible flicker. PWM frequencies of 200 Hz or greater usually avoid flicker problems. The electrical connector according to this embodiment may additionally comprise an input terminal 178 for inputting a signal that is controlling the PWM unit 174.

According to the present invention, the PWM unit 174 is supplied with an analog DC signal, e. g. a 0 V to 10 V signal. The value 0 V represents an OFF state of the LED 138, whereas 10 V represent the maximum brightness, i. e. 100 % brightness. According to the voltage present at the input terminal 178 the PWM unit 174 generates a pulse train that is input to the control terminal 176 of the driver unit 172. The PWM unit 174 thus translates the analog value into a pulse train that switches the LED 138 on and off to emit a desired average luminous flux. The PWM level is set by the 0 V to 10 V signal.

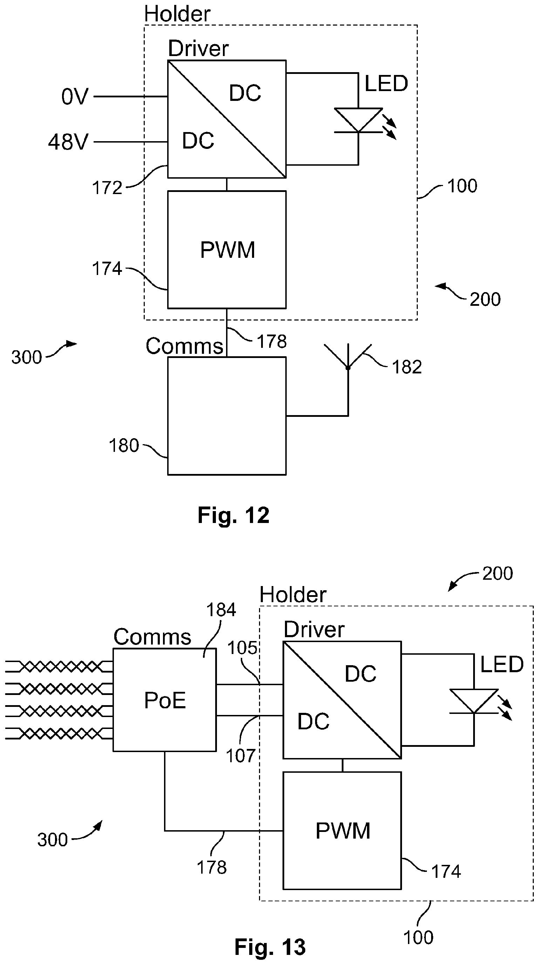

Fig. 12 shows a further advantageous embodiment of the light emitter module 200 according to the present invention, where the light emitter module 200 is part of a lighting system 300. According to this embodiment, the input terminal 178 of the PWM 174 is connected to a wireless communication unit 180. The wireless communication unit 180 may comprise an antenna 182 for transmitting and receiving wireless signals to/from an external controller (not shown in the figures). According to the present invention, the wireless communication unit 180 may comprise a radio communication unit, such as for instance Bluetooth or 6LoWPAN (IPv6 over Low power Wireless Personal Area Network), or an infrared communication unit.

Instead of a wireless connection, the light emitter module 200 may also be connected to a wirebound communication unit 184. Such an architecture is shown in Fig. 13. For instance, the wirebound communication unit 184 may comprise a power over Ethernet (PoE) communication device. The advantage of this solution is the compatibility to existing PoE setups. In the case of a PoE communication unit 184 the DC voltage at the second terminal 107 may for instance be between 42.5 V and 57 V. The DC signal 178 that is provided to the PWM unit 174 is advantageously between 0 V and 10V, so that the PWM level is set by the 0 V to 10 V signal.

The wirebound communication unit 184 may also be an integral part of the socket assembly 100, being assembled on the isolator PCB 102 (not shown in the Figures). In this case the electrical connector 106 may be a corresponding standard PoE connector.

Instead of the PoE architecture as shown in Figure 13, any other wirebound communication structure may also be used according to the present invention, essentially replacing the antenna 182 of Figure 12 by a wire connection.

**Bezugszeichenliste:**

| **Bezugszeichen** | **Beschreibung** |
|---|---|
| 100 | Socket assembly |
| 200 | Light emitter module |
| 300 | Lighting system |
| 102 | Isolator printed circuit board (PCB) |
| 104 | Electrical contact element |
| 105 | First input terminal |
| 106 | Electrical connector |
| 107 | Second input terminal |
| 108 | Base frame |
| 110 | Second surface of PCB |
| 112 | First surface of PCB |
| 114 | Recess for LED package |
| 115 | Cut-out in PCB |
| 116 | Spring element |
| 118 | Body |
| 120 | Base |
| 122 | Spring finger |
| 124 | Anvil |
| 126 | End of anvil |
| 128 | Cover |
| 130 | Opening |
| 132 | Cut-out in cover |
| 134 | LED package, |
| 136 | LED PCB |
| 138 | LED, light emitting element |
| 140, 142 | Sides of LED PCB |
| 144 | Power pad |
| 146 | Electronic component |
| 148, 150 | Sides of cover |
| 152 | Opening for anvils |
| 154 | Opening for LED |
| 156 | Solder pad |
| 158 | Notch |
| 160 | Contact region |
| 162 | Connecting region |
| 164 | Connecting pin |
| 166 | Connecting receptacle |
| 168 | Force of spring elements 116 |
| 170 | Resilient base of anvil |
| 172 | DC/DC driver unit |
| 174 | Dimming unit |
| 176 | Control terminal |
| 178 | Input terminal of PWM |
| 180 | Wireless communication unit |
| 182 | Antenna |
| 184 | Wirebound communication unit |

## Claims

1. Socket assembly (100) comprising:
a thermally conductive base frame (108) for holding a light emitter package (134) to a support structure, the light emitter package (134) having a light emitter substrate (136) with a light emitting element (138) mounted thereto, wherein the base frame (108) comprises a base (120) that is configured to be mounted to the support structure and is further configured to mechanically engage the light emitter substrate (136) of the light emitter package (134), so that the light emitter package (134) is attachable to the support structure with a pre-determined holding force;
at least one electrical contact element (104) for electrically contacting said light emitter package (134); and
an isolator printed circuit board, PCB, (102) comprising a plurality of electrically conductive leads, wherein the electrical contact element (104) is arranged on the isolator PCB (102) and configured to electrically connect the isolator PCB (102) to the light emitter substrate (136), the isolator PCB (102) being configured to be electrically connected to an electrical power supply for supplying electrical power to the light emitting element (138); wherein the isolator PCB (102) has a first surface (112) and a second surface (110), the second surface (110) being in heat transmitting contact with the base frame (108), such that the base frame (108) is configured to absorb heat from the isolator PCB (102), and wherein the socket assembly further comprises at least one electronic component (146), which is arranged on said first surface (112) of the isolator PCB (102) and is electrically connectable to said light emitting element (138),
wherein the socket assembly (100) further comprises a cover (128) that includes an opening (154)
that is configured to expose the light emitting element (138), the cover (128) comprising a retention feature that cooperates with a retention member of the base frame (108) to mechanically connect the cover to the base frame (108), wherein the retention member passes through the isolator PCB (102).

2. Socket assembly according to claim 1, wherein said at least one electronic component (146) comprises a driver unit (172) for providing a controlled power to said light emitting element (138).

3. Socket assembly according to claim 1 or 2, wherein said at least one electronic component (146) comprises a communication interface (180, 184) for communication with an external controller.

4. Socket assembly according to one of the preceding claims, wherein the at least one electronic component (146) comprises a dimming unit (174) for controlling a luminous flux emitted by the light emitting element (138).

5. Socket assembly according to claim 4, wherein said dimming unit (174) comprises a pulse width modulator PWM, unit.

6. Socket assembly according to claims 2 and 5, wherein the PWM unit has an input terminal and an output terminal, wherein the PWM unit is operable to receive an analog DC or digital control signal at the input terminal, and wherein the output terminal is connected to the driver unit (172) to provide to the driver unit (172) an alternating PWM signal in response to the analog DC or digital control signal.

7. Socket assembly according to one of the preceding claims, wherein the at least one electrical contact element (104) is resilient and is arranged to exert a defined force on the light emitter package (134).

8. Socket assembly according to one of the preceding claims, further comprising an electrical connector (106) that is arranged on the isolator PCB (102) and is configured to be mated with a mating connector for supplying power to the light emitting element (138).

9. Socket assembly according to one of the preceding claims, wherein the thermally conductive base frame (108) comprises at least one resilient element (116, 122) that extends from the base (120), the resilient element (116, 122) being configured to engage the light emitter substrate (136) of the light emitter package (134) and to apply a clamping force to the light emitter substrate (136).

10. Socket assembly according to one of the preceding claims, wherein the thermally conductive base frame (108) is fabricated from a stamped and bent metal sheet.

11. Light emitter module (200) comprising a socket assembly according to one of the preceding claims and a light emitter package (134) having a light emitter substrate (136) with a light emitting element (138) mounted thereto.

12. Lighting system comprising a light emitter module (200) according to claim 11 and an inline control unit for controlling said at least one electronic component (146), wherein the inline control unit is connected to the isolator PCB (102) via a cable.

13. Lighting system according to claim 12, wherein said inline control unit comprises a wireless communication interface element (180) or a wirebound communication interface element (184).

14. Lighting system according to claim 13, wherein the wireless communication interface element (180) or wirebound communication interface element (184) are operable to output an analog DC or a digital control signal to an input terminal of a PWM unit for controlling a luminous flux emitted by the light emitting element (138).

## Patentansprüche

1. Fassungs-Anordnung (100), die umfasst:
einen wärmeleitenden Sockel (108) zum Halten einer Lichtemissions-Baugruppe (134) an einer Tragestruktur, wobei die Lichtemissions-Baugruppe (134) ein Lichtemissions-Substrat (136) mit einem daran angebrachten lichtemittierenden Element (138) aufweist, der Sockel (108) eine Grundfläche (120) umfasst, die zum Anbringen an der Tragestruktur ausgeführt ist und des Weiteren so ausgeführt ist, dass sie mechanisch mit dem Lichtemissions-Substrat (136) der Lichtemissions-Baugruppe (134) in Eingriff kommt, so dass die Lichtemissions-Baugruppe (134) mit einer vorgegebenen Haltekraft an der Tragestruktur angebracht werden kann;
wenigstens ein elektrisches Kontaktelement (104) zum Herstellen von elektrischem Kontakt mit der Lichtemissions-Baugruppe (134); und
eine Isolator-Leiterplatte (102), die eine Vielzahl elektrisch leitender Zuleitungen umfasst, wobei das elektrische Kontaktelement (104) auf der Isolator-Leiterplatte (102) angeordnet und so ausgeführt ist, dass es die Isolator-Leiterplatte (102) elektrisch mit dem Lichtemissions-Substrat (136) verbindet, und die Isolator-Leiterplatte (102) so ausgeführt ist, dass sie elektrisch mit einer Stromquelle zum Zuführen von elektrischem Strom zu dem lichtemittierenden Element (138) ausgeführt ist;
wobei die Isolator-Leiterplatte (102) eine erste Fläche (112) und eine zweite Fläche (110) aufweist, wobei die zweite Oberfläche (110) in wärmeübertragendem Kontakt mit dem Sockel (108) ist, so dass der Sockel (108) zum Absorbieren von Wärme von der Isolator-Leiterplatte (102) ausgeführt ist, und die Fassungs-Anordnung des Weiteren wenigstens ein elektronisches Bauteil (146) umfasst, das auf der ersten Fläche (112) der Isolator-Leiterplatte (102) angeordnet ist und elektrisch mit dem lichtemittierenden Element (138) verbunden werden kann,
wobei die Fassungs-Anordnung (100) des Weiteren eine Abdeckung (128) umfasst, die eine Öffnung (154) enthält, die so ausgeführt ist, dass sie das lichtemittierende Element (138) freilegt, die Abdeckung (128) eine Rückhalte-Struktur umfasst, die mit einem Rückhalte-Element des Sockels (108) zusammenwirkt, um die Abdeckung mechanisch mit dem Sockel (108) zu verbinden, und das Rückhalte-Element durch die Isolator-Leiterplatte (102) hindurchtritt.

2. Fassungs-Anordnung nach Anspruch 1, wobei das wenigstens eine elektronische Bauteil (146) eine Treiber-Einheit (172) zum Bereitstellen einer gesteuerten Leistung für das lichtemittierende Element (138) umfasst.

3. Fassungs-Anordnung nach Anspruch 1 oder 2, wobei das wenigstens eine elektronische Bauteil (146) eine Kommunikations-Schnittstelle (180, 184) für Kommunikation mit einer externen Steuerungseinrichtung umfasst.

4. Fassungs-Anordnung nach einem der vorangehenden Ansprüche, wobei das wenigstens eine elektronische Bauteil (146) eine Dimm-Einheit (174) zum Steuern eines von dem lichtemittierenden Element (138) emittierten Lichtstroms aufweist.

5. Fassungs-Anordnung nach Anspruch 4, wobei die Dimm-Einheit (174) eine Pulsweitenmodulations-Einheit umfasst.

6. Fassungs-Anordnung nach Anspruch 2 und 5, wobei die Pulsweitenmodulations-Einheit einen Eingangsanschluss und einen Ausgangsanschluss aufweist, die Pulsweitenmodulations-Einheit so betrieben werden kann, dass sie ein analoges Gleichstrom- oder digitales Steuersignal an dem Eingangsanschluss empfängt, und der Ausgangsanschluss mit der Treiber-Einheit (172) verbunden ist, um der Treiber-Einheit (172) in Reaktion auf das analoge Gleichstrom- oder digitale Steuersignal ein wechselndes Pulsweitenmodulations-Signal bereitzustellen.

7. Fassungs-Anordnung nach einem der vorangehenden Ansprüche, wobei das wenigstens eine elektrische Kontaktelement (104) elastisch ist und so eingerichtet ist, dass es eine bestimmte Kraft auf die Lichtemissions-Baugruppe (134) ausübt.

8. Fassungs-Anordnung nach einem der vorangehenden Ansprüche, des Weiteren umfassend einen elektrischen Verbinder (106), der an der Isolator-Leiterplatte (102) angeordnet und so ausgeführt ist, dass er mit einem Gegenverbinder gekoppelt wird, um dem lichtemittierenden Element (138) Strom zuzuführen.

9. Fassungs-Anordnung nach einem der vorangehenden Ansprüche, wobei der wärmeleitende Sockel (108) wenigstens ein elastisches Element (116, 122) umfasst, das sich von der Grundfläche (120) aus erstreckt, und das elastische Element (116, 122) so ausgeführt ist, dass es mit dem Lichtemissions-Substrat (136) der Lichtemissions-Baugruppe (134) in Eingriff kommt und eine Klemmkraft auf das Lichtemissions-Substrat (136) ausübt.

10. Fassungs-Anordnung nach einem der vorangehenden Ansprüche, wobei der wärmeleitende Sockel (108) aus einem gestanzten und gebogenen Blech hergestellt ist.

11. Lichtemissions-Modul (200), umfassend eine Fassungs-Anordnung nach einem der vorangehenden Ansprüche und eine Lichtemissions-Baugruppe (134), die ein Lichtemissions-Substrat (136) mit einem darauf montierten lichtemittierenden Element (138) aufweist.

12. Beleuchtungssystem, das ein Lichtemissions-Modul (200) nach Anspruch 11 und eine integrierte (inline) Steuerungs-Einheit zum Steuern des wenigstens einen elektronischen Bauteils (146) umfasst, wobei die integrierte Steuerungs-Einheit über ein Kabel mit der Isolator-Leiterplatte (102) verbunden ist.

13. Beleuchtungssystem nach Anspruch 12, wobei die integrierte Steuerungs-Einheit ein Schnittstellenelement (180) für drahtlose Kommunikation oder ein Schnittstellenelement (184) für drahtgebundene Kommunikation umfasst.

14. Beleuchtungssystem nach Anspruch 13, wobei das Schnittstellenelement (180) für drahtlose Kommunikation oder das Schnittstellenelement (184) für drahtgebundene Kommunikation so betrieben werden kann, dass es ein analoges Gleichstrom- oder ein digitales Steuersignal an einen Eingangsanschluss einer Pulsweitenmodulations-Einheit ausgibt, um einen von dem lichtemittierenden Element (138) emittierten Lichtstrom zu steuern.

## Revendications

1. Ensemble douille (100) comprenant :
un cadre de base thermoconducteur (108) pour maintenir un boîtier émetteur de lumière (134) sur une structure de support, le boîtier émetteur de lumière (134) ayant un substrat émetteur de lumière (136) avec un élément électroluminescent (138) monté sur celui-ci, dans lequel le cadre de base (108) comprend une base (120) qui est configurée pour être montée sur la structure de support et est en outre configurée pour s'engager mécaniquement avec le substrat émetteur de lumière (136) du boîtier émetteur de lumière (134), de sorte que le boîtier émetteur de lumière (134) puisse être fixé à la structure de support avec une force de maintien prédéterminée ;
au moins un élément de contact électrique (104) pour entrer en contact électrique avec ledit boîtier émetteur de lumière (134) ; et
une carte de circuit imprimé, PCB, soit printed circuit board, isolante (102) comprenant une pluralité de fils électroconducteurs, où l'élément de contact électrique (104) est agencé sur la PCB isolante (102) et configuré pour relier électriquement la PCB isolante (102) au substrat émetteur de lumière (136), la PCB isolante (102) étant configurée pour être électriquement reliée à une alimentation électrique pour fournir de la puissance électrique à l'élément électroluminescent (138) ;
dans lequel la PCB isolante (102) a une première surface (112) et une deuxième surface (110), la deuxième surface (110) étant en contact de transmission de chaleur avec le cadre de base (108), de sorte que le cadre de base (108) soit configuré pour absorber la chaleur provenant de la PCB isolante (102), et
dans lequel l'ensemble douille comprend en outre au moins un composant électronique (146), qui est agencé sur ladite première surface (112) de la PCB isolante (102) et peut être électriquement relié audit élément électroluminescent (138),
dans lequel l'ensemble douille (100) comprend en outre un couvercle (128) qui comporte une ouverture (154) qui est configurée pour exposer l'élément électroluminescent (138), le couvercle (128) comprenant un élément de retenue qui coopère avec un organe de retenue du cadre de base (108) pour relier mécaniquement le couvercle au cadre de base (108), où l'organe de retenue passe à travers la PCB isolante (102).

2. Ensemble douille selon la revendication 1, dans lequel ledit au moins un composant électronique (146) comprend une unité de pilotage (172) pour fournir une puissance commandée audit élément électroluminescent (138).

3. Ensemble douille selon la revendication 1 ou 2, dans lequel ledit au moins un composant électronique (146) comprend une interface de communication (180, 184) pour la communication avec un dispositif de commande externe.

4. Ensemble douille selon l'une des revendications précédentes, dans lequel l'au moins un composant électronique (146) comprend une unité de gradation (174) pour commander un flux lumineux émis par l'élément électroluminescent (138).

5. Ensemble douille selon la revendication 4, dans lequel ladite unité de gradation (174) comprend une unité de modulateur d'impulsions en largeur, PWM, soit pulse width modulator.

6. Ensemble douille selon les revendications 2 et 5, dans lequel l'unité PWM a une borne d'entrée et une borne de sortie, dans lequel l'unité PWM peut fonctionner pour recevoir un signal de commande analogique CC ou numérique au niveau de la borne d'entrée, et dans lequel la borne de sortie est reliée à l'unité de pilotage (172) pour fournir à l'unité de pilotage (172) un signal PWM alternatif en réponse au signal de commande analogique CC ou numérique.

7. Ensemble douille selon l'une des revendications précédentes, dans lequel l'au moins un élément de contact électrique (104) est élastique et est agencé pour exercer une force définie sur le boîtier émetteur de lumière (134).

8. Ensemble douille selon l'une des revendications précédentes, comprenant en outre un connecteur électrique (106) qui est agencé sur la PCB isolante (102) et est configuré pour être accouplé à un connecteur d'accouplement pour alimenter l'élément électroluminescent (138) en puissance.

9. Ensemble douille selon l'une des revendications précédentes, dans lequel le cadre de base thermoconducteur (108) comprend au moins un élément élastique (116, 122) qui s'étend depuis la base (120), l'élément élastique (116, 122) étant configuré pour s'engager avec le substrat émetteur de lumière (136) du boîtier émetteur de lumière (134) et pour appliquer une force de serrage sur le substrat émetteur de lumière (136).

10. Ensemble douille selon l'une des revendications précédentes, dans lequel le cadre de base thermoconducteur (108) est fabriqué à partir d'une feuille métallique estampée et pliée.

11. Module émetteur de lumière (200) comprenant un ensemble douille selon l'une des revendications précédentes et un boîtier émetteur de lumière (134) ayant un substrat émetteur de lumière (136) avec un élément électroluminescent (138) monté sur celui-ci.

12. Système d'éclairage comprenant un module émetteur de lumière (200) selon la revendication 11 et une unité de commande en ligne pour commander ledit au moins un composant électronique (146), dans lequel l'unité de commande en ligne est reliée à la PCB isolante (102) par l'intermédiaire d'un câble.

13. Système d'éclairage selon la revendication 12, dans lequel ladite unité de commande en ligne comprend un élément d'interface de communication sans fil (180) ou un élément d'interface de communication filaire (184).

14. Système d'éclairage selon la revendication 13, dans lequel l'élément d'interface de communication sans fil (180) ou l'élément d'interface de communication filaire (184) peut fonctionner pour délivrer en sortie un signal de commande analogique CC ou numérique à une borne d'entrée d'une unité PWM pour commander un flux lumineux émis par l'élément électroluminescent (138).
